# EUROPÄISCHE PATENTSCHRIFT

(11) **EP 0 348 698 B1**
(45) Veröffentlichungstag und Bekanntmachung des Hinweises auf die Patenterteilung: **08.12.1993**
(21) Anmeldenummer: 89110185.9
(22) Anmeldetag: 06.06.1989
(51) Int. Cl.: H03J 5/24, H03B 5/24

(54) **Eingangsschaltung eines Fernsehtuners**
Television tuner input circuit
Circuit d'entrée d'un tuner pour récepteur de télévision

(30) Priorität: 28.06.1988 DE 3821715
(43) Veröffentlichungstag der Anmeldung: 03.01.1990
(73) Patentinhaber: TEMIC TELEFUNKEN microelectronic GmbH, 74072 Heilbronn (DE)
(72) Erfinder: Franz, Heigl, Dipl.-Ing. (FH), D-8079 Ochsenfeld (DE)
(74) Vertreter: Maute, Hans-Jürgen, Dipl.-Ing.

(56) Entgegenhaltungen:
- EP-A- 0 196 130
- DE-A- 2 929 901
- GB-A- 2 196 197
- GB-A- 2 196 198

## Beschreibung

Die Erfindung betrifft eine Eingangsschaltung gemäß dem Oberbegriff des ersten Anspruchs.

Eine bekannte Eingangsschaltung dieser Art (DE-C 35 09 516) ist für das Frequenzband von VHF-Band 1 bis einschließlich Hyperband, also von etwa 50-470 MHz mittels zweier Bereichschalter auf drei Empfangsfrequenzbereiche, nämlich VHF-Band I, VHF-Band III und Hyperband umschaltbar. Dabei ist ein Vorkreis aus einem frequenzbestimmenden, veränderbaren Kondensator und der Serien-Parallelschaltung von fünf frequenzbestimmenden Spulen vorgesehen. Drei in Serie geschaltete Spulen liegen dabei parallel zum Kondensator, der wie die erste Spule dieser Serienschaltung einendig an Masse geschaltet ist. Parallel zu dieser ersten Spule liegt die Serienschaltung aus zwei weiteren Spulen. Für den VHF-Bereich I sind alle fünf Spulen frequenzbestimmend, während für das VHF-Band III mittels eines ersten Bereichschalters die mittlere Spule der aus drei Spulen gebildeteten Serienschaltung kurzgeschlossen wird. Für die Selektion im Hyperband wird der Verbindungspunkt zwischen den beiden Spulen der zusätzlichen zweispuligen Serienschaltung an den Ausgang der Eingangsschaltung gelegt, an welchem auch der zweite Anschluß des Kondensators liegt. Bei diesem Schaltungsaufbau sind fünf frequenzbestimmende Spulen erforderlich, die nicht nur einzeln hergestellt und in den Schaltungsaufbau eingefügt sondern beim Frequenzabgleich auch einzeln abgeglichen werden müssen. Dabei beeinflussen sich die beiden Serienschaltungen gegenseitig, so daß sich eine Inuduktivitätsänderung in der Serienschaltung für die beiden VHF-Bänder auch im Hyperband auswirkt und umgekehrt. Zudem sind auch zwei Bereichschalter erforderlich, für die eigene Gleichstromkreise für die Umschaltung notwendig sind.

Der Erfindung liegt die Aufgabe zugrunde, eine Eingangsschaltung zu schaffen, die einen minimierten Aufwand an Bauteilen und Abgleicharbeiten erfordert und gleichzeitig eine Leistungsanpassung des hochohmigen Eingangs der nachgeschalteten Vorstufe an den niederohmigen Antennenanschluß bewirkt.

Die Lösung dieser Aufgabe erfolgt gemäß der Erfindung durch die Merkmale des ersten Anspruchs.

Bei einer Eingangsschaltung gemäß der Erfindung sind nur drei frequenzbestimmende Spulen notwendig, die so bemessen sind, daß in Verbindung mit dem einzigen Bereichschalter das gesamte zu überstreichende Frequenzband in zwei Frequenzbereiche unterteilt ist. Insbesondere ist die kapazitive Belastung durch diese Spulen nur sehr gering, so daß sich ein großer Frequenzdurchstimmbereich ergibt, der nur eine Teilung in zwei Frequenzbänder erfordert. Im niedrigen Frequenzbereich sind dabei alle drei frequenzbestimmenden Spulen wirksam, während im hohen Frequenzbereich nur die erste Spule frequenzbestimmend ist, während die beiden anderen als Parallelschaltung in Serie zum Antennenanschluß liegen und der Leistungsanpassung dienen. Die Leistungsanpassung im niedrigen Frequenzbereich ist dabei durch die ebenfalls in Serie mit dem Antennenanschluß liegende Anpassungsspule und deren Anschluß an den Verbindungspunkt zwischen der zweiten und der dritten Spule der Serienschaltung gegeben. Abgleicharbeiten zur Anpassung der Induktivitätswerte können dabei für den niedrigen Frequenzbereich an der zweiten bzw. dritten Spule und für den hohen Frequenzbereich an der ersten Spule vorgenommen werden. Dabei wirkt sich eine Änderung des Induktivitätswert der ersten Spule im niedrigen Frequenzbereich praktisch nicht aus, weil deren Induktivitätswert vergleichsweise gering zur Gesamtinduktivität der Serienschaltung ist. Auch eine Änderung der Anpassungsspule wirkt sich auf den eingestellten Frequenzbereich nicht aus. Dabei ist die Anpassungsspule für die Leistungsanpassung im hohen Frequenzbereich bestimmt. Die Eingangsschaltung ist vorzugsweise Teil einer gesamten Tunerschaltung, wobei der Ausgang des Vorkreisfilters an einen Eingang eines gemeinsamen Vorverstärkers angeschaltet ist, dessen Ausgang an einer zweistufige Umschalteinrichtung liegt, die gleichzeitig mit dem Vorkreisfilter umgeschaltet wird und an die getrennt eigenständige Bandfilter angeschlossen sind, deren Ausgänge je an einer eigenen Mischstufe mit separater Zwischenfrequenzselektion liegen.

Andere vorteilhafte Weiterbildungen der Erfindung sind in den übrigen Ansprüchen angegeben.

Die Erfindung ist nachfolgend anhand der Schaltungsskizzen eines Ausführungsbeispiels näher erläutert.

Es zeigt:
Figur 1 ein Blockschaltbild eines gemäß der Erfindung aufgebauten Tuners,
Figur 2 eine Schaltung der hochfrequenzmäßig wirksamen Bauteile des Vorselektionsteils,
Figur 3 eine Schaltungsanordnung zur Anschaltung von Bandfiltern an die Vorstufe und
Figur 4 die mit Gleichstromwegen ergänzte Schaltungsanordnung nach Figur 3.

Ein Fernsehtuner ist mit einem gemeinsamen Antennenanschluß 1 ausgestattet, von dem ein erster Bereichsumschalter 2 zu einem Tunerzweig für die Frequenzen des VHF-Bandes I bis einschließlich Hyperband, also von ca. 50 bis 470 MHz, und ein zweiter Bereichsumschalter 3 zu einem UHF-Tunerzweig führen.

Der UHF-Tunerzweig ist aus einem Vorkreisfilter 4 mit nachfolgendem Vorverstärker 5 und daran anschließendem Bandfilter 6 mit nachfolgender Mischstufe 7 gebildet, der ein eigenständiger Oszillator 8 zugeordnet ist. Die UHF-Mischstufe 7 ist mit einem Zwischenfrequenzselektor 9 gekoppelt, dem ein Zwischenfrequenzverstärker 10 mit einem Zwischenfrequenzausgang 11 nachfolgt.

An den ersten Bereichsumschalter 2 ist dagegen ein Vorkreisfilter 12 angeschlossen, das auf einen niedrigen (ca. 50 bis 150 MHz) und einen direkt anschließenden höheren Frequenzbereich (ca. 150 bis 470 MHz) umschaltbar ist. Dieses für die beiden Frequenzbereiche kombinierte Vorkreisfilter 12 ist mit seinem gemeinsamen Filterausgang 13 an den Eingang 14 eines gemeinsamen Vorverstärkers 15 angeschaltet. Der Ausgang 16 des Vorverstärkers 15 liegt an einer zweistufigen Umschalteinrichtung 17, an deren Ausgänge einerseits der Eingang 18 eines für den tiefen Frequenzbereich bemessenen eigenständigen Bandfilters 19 und an dessen anderen Ausgang der Eingang 20 eines für den hohen Frequenzbereich bemessenen eigenständigen Bandfilters 21 angeschlossen ist. Die Umschaltung des Vorkreisfilters und der Umschalteinrichtung 17 erfolgt jeweils gleichzeitig über eine strichpunktiert angedeutete Schaltverbindung 22 abhängig vom ausgewählten Frequenzbereich. Die Ausgänge 23 bzw. 24 der Bandfilter 19 bzw. 21 sind jeweils auf eine eigenständige Mischstufe 25 bzw. 26 geschaltet. Auch den Mischstufen 25 und 26 ist je ein eigener Oszillator 27 bzw. 28 zugeordnet. Ferner sind die Mischstufen 25 und 26 unabhängig voneinander an den gemeinsamen Zwischenfrequenzkreis 9 angeschlossen. Die Mischstufen und Oszillatoren sind Teil einer integrierten Tunerschaltung 29, beispielsweise vom Typ TDA 5330 T oder TUA 2007. Die getrennten Bandfilter 19 bzw. 21 ermöglichen dabei eine sehr hohe Empfangsempfindlichkeit bei großer Störsicherheit, weil sie optimal für den entsprechenden Frequenzbereich bemessen sein können und keine die Selektion beeinflussenden Schaltdioden erfordern. Es sind daher auch keine gesonderten Umschaltspannungen für die Schaltdioden erforderlich. Zur hohen Selektion und Störsicherheit trägt auch die jeweils eigenständig Mischstufe bei, so daß übliche Kompromisse für die Mischstu fenbeschaltung entfallen.

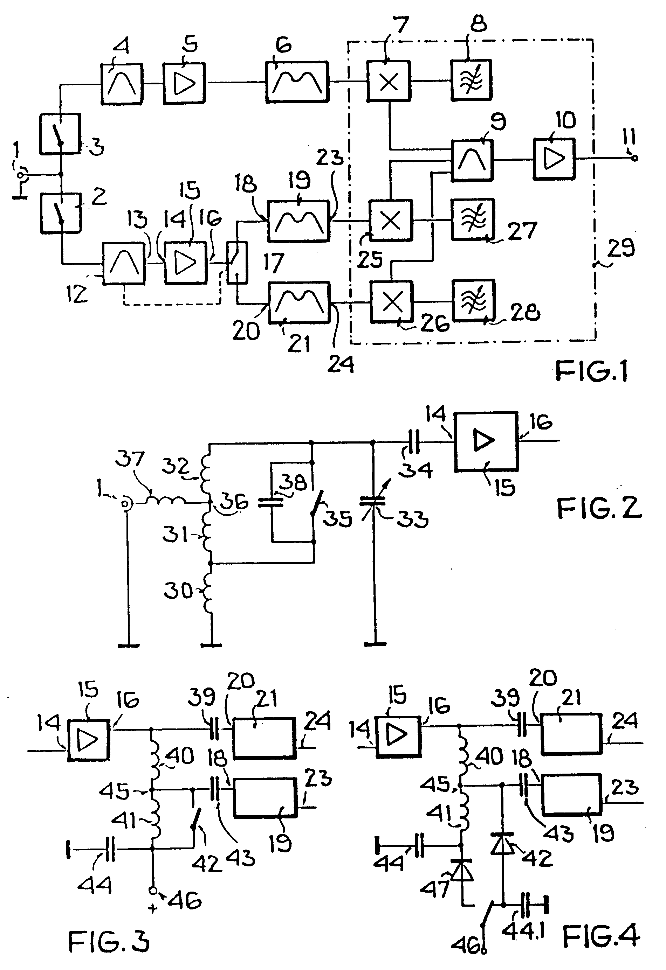

Die Vorkreis- und Vorverstärkerschaltung ist ohne Berücksichtigung des ersten Bereichsumschalters 2 in Figur 2 dargestellt. Das Vorkreisfilter besteht demnach aus der Serienschaltung von drei frequenzbestimmenden Spulen 30, 31, 32, zu welchen ein gemeinsamer frequenzbestimmender Kondensator 33 vorzugsweise in Form einer spannungssteuerbaren Kapazitätsdiode 33 parallel geschaltet ist. Die erste Spule 30 ist dabei einseitig an Massepotential und die dritte Spule 32 über einen Trennkondensator 34 an den Eingang 14 des Vorverstärkers 15 angeschlossen. Parallel zur Serienschaltung aus der zweiten und der dritten Spule 31 bzw. 32 liegt dagegen ein Bereichschalter 35, der insbesondere als gleichstrommäßig steuerbare Schaltdiode ausgebildet ist. Vom Verbindungspunkt 36 zwischen der zweiten und der dritten Spule 31 bzw. 32 führt eine Anpassungsspule 37 zum Antennenanschluß 1. In der dargestellten Schaltstellung gemäß Figur 2 ist das Vorkreisfilter 12 für den niedrigen Frequenzbereich bemessen, der von zirka 50 bis 150 MHz reicht. Innerhalb dieses Frequenzbereichs ist die Anpassungsspule 37 besonders bei den niedrigen Frequenzen weitgehend ohne Wirkung. Die Grund-Anpassung erfolgt hier durch das Teilungsverhältnis der Induktivitätswerte der Spulen 30, 31 und 32. Durch die Kapazitätsvariation des Kondensators 33 läßt sich so der niedrige Frequenzbereich durchstimmen, in dem alle drei Spulen 30, 31 und 32 frequenzbestimmend sind. Da der Frequenzvariationsbereich im niedrigen Frequenzbereich etwas kleiner ist als im hohen Frequenzbereich, der von zirka 150 bis 470 MHz reicht, kann parallel zum Bereichschalter 35 ein Korrekturkondensator 38 geschaltet werden, der den wirksamen Variationsbereich des Kondensators 33 bei geöffnetem Bereichsschalter 35 im erforderlichen Maß begrenzt. Der Bereichschalter 35 dient so gleichzeitig zur Änderung des Durchstimmverhältnisses.

Wird der Bereichschalter 35 geschlossen, dann ist allein die Spule 30 mit ihrer geringen Eigenkapazitätunmittelbar parallel zum Kondensator 33 geschaltet und bestimmt so den hohen Frequenzbereich. Bei geschlossenem Bereichschalter 35 ist auch der Korrekturkondensator 35 kurzgeschlossen und damit der Kondensator 33 mit seinem gesamten Variationsbereich allein frequenzbestimmend. Zusätzlich wird bei geschlossenem Bereichschalter 35 auch die Serienschaltung aus den Spulen 31 und 32 zu einer Parallelschaltung, die in Serie mit der Anpassungsspule 37 liegt. Die Spulen 31, 32 und 37 dienen dann gemeinsam der Anpassung des Vorkreisfilterkreises an den Wellenwiderstand der Antennenleitung, wobei dann für den Abgleich der Anpassung die Anpassungsspule 37 in ihrem Induktivitätswert verändert werden kann. Diese Änderung wirkt sich im niedrigeren Frequenzbereich praktisch nicht aus. Auch beeinflußt eine für den Abgleich des Schwingkreises gegebenenfalls vorzunehmende Änderung des Induktivitätswerts der Spule 30 die Schwingfrequenz des gesamten Schwingkreises im niedrigeren Frequenzbereich nur unerheblich, weil der Induktivitätswert der Spule 30 im Vergleich zum Gesamtinduktivitätswert der Spulen 31 und 32 klein ist. Diese Vorkreisschaltung erfordert auch nur einen gemeinsamen Vorverstärker 15, so daß mit nur einem Bereichschalter 35 eine Frequenzbereichumschaltung, eine Änderung des Abstimmverhältnisses und eine Umschaltung der Anpassung in den Frequenzbereichen erfolgt. Für diese minimale Zahl an Bauteilen ist somit auch nur ein entsprechend kleiner Raum im Tunergehäuse erforderlich, ohne die Selektion und Störsicherheit nachteilig zu beeinflussen.

An den Ausgang 16 des Vorverstärkers 15 ist die Umschalteinrichtung 17 für die Bandfilter 19 bzw. 21 angeschlossen, wobei die Umschalteinrichtung einen Kondensator 39 aufweist, der vom Ausgang 16 an den Eingang 20 des Bandfilters 21 für den hohen Frequenzbereich geschaltet ist. Eine Spule 40 führt vom Ausgang 16 über die Parallelschaltung aus einer Hochfrequenzdrossel 41 sowie einem Bandschalter 42 zu einer Stromversorgungsquelle 46 bzw. über einen Kondensator 43 zum Eingang 18 des Bandfilters 19 für den tiefen Frequenzbereich. Der Bandschalter 42 ist wie die Hochfrequenzdrossel 41 über einen Abblockkondensator 44 hochfrequenzmäßig an Massepotential angeschaltet. Bei geschlossenem Bandschalter 42, der vorzugsweise ebenfalls eine Schaltdiode ist und zusammmen mit dem Bereichsschalter 35 gesteuert wird, bildet der Hochpaßkondensator 39 mit der Hochpaßspule 40 einen Bandpaß für den hohen Frequenzbereich, wobei der Verindungspunkt 45 der Spule 40 mit dem Kondensator 43 über den Bandschalter 42 an Massepotential angeschlossen ist. Das Bandfilter 19 für den tiefen Frequenzbereich ist somit hochfrequenzmäßig eingangsseitig und kurzgeschlossen. Das Hochpaßfilter 39, 40 ermöglicht somit eine optimale Anpassung zwischen dem Vorverstärker 15 und dem Bandfilter 21.

Bei nicht leitendem, also offenem Bandschalter 42 bildet dagegen die Spule 40 mit dem Kondensator 43 und der über die Eingangsimpedanz des Bandfilters 21 geerdeter Kondensator 39 einen Tiefpaß für den tiefen Frequenzbereich, wobei das angeschaltete Bandfilter 19 seinerseits das Bandfilter 21 eingangsseitig für den hohen Frequenzbereich so weitgehend verstimmt, daß auch dort eine Selektion bestimmter Frequenzen nicht mehr möglich ist.

Durch die Hochfrequenzdrossel 41 ist bei geöffnetem Bandschalter 42 ein Gleichstromweg zum Ausgang 16 des Verstärkers 15 gegeben, so daß über diesen Weg das im Vorverstärker 15 vorhandene Verstärkerelement mit Gleichstrom versorgt werden kann, ohne den Tiefpaß zu beeinflussen.

In Figur 4 ist eine Schaltungsanordnung gemäß Figur 3 dargestellt, bei der als Bandschalter eine Schaltdiode 42 verwendet ist. Dort ist bei sonst gleichem Schaltungsaufbau in Serie mit der Hochfrequenzdrossel 41 eine einfache Diode 47 vorgesehen, über welche die Gleichstromspeisung des Vorverstärkers 15 erfolgt, wenn der niedrige Frequenzbereich eingeschaltet sein soll. In diesem Falle ist die Schaltdiode 42 stromlos und damit gesperrt, der Bandschalter also offen. Wird dagegen die Schaltdiode 42 an die Gleichstromquelle 46 angeschaltet, dann bewirkt der sie durchfließende Strom das Durchschalten, wodurch der Bandschalter geschlossen ist. Die Schaltungsanordnung ist dann für den hohen Frequenzbereich umgeschaltet, nachdem dann der Verbindungspunkt 45 über die Schaltdiode 42 und den zugeordneten Abblockkondensator 44.1 an Massepotential liegt. Bei der Umschalteinrichtung 17 liegt die Schaltdiode 42 bzw. der Bandschalter nicht in einem frequenzbestimmenden Schwingkreis, so daß die Selektion nachteilig beeinflussende Wirkungen nicht auftreten.

## Patentansprüche

1. Eingangsschaltung eines Fernsehtuners für das Frequenzband von VHF-Band I bis einschließlich Hyperband mit Vorkreisfilter (12) aus einem für den gennanten Frequenzbereich frequenzbestimmenden Kondensator (33) und einer parallel dazu geschalteten Serienschaltung aus drei für den niedrigen Frequenzbereich frequenzbestimmenden Spulen (30,31,32), von welchen die erste (30) wie der Kondensator (33) einendig an Massepotential und die dritte (32) wie der Kondensator (33) einendig an einem Ausgang der Eingangsschaltung liegen, mit einem in diese Serienschaltung eingefügten Bereichsschalter (35) sowie mit einem Antennenanschluß (1) und einer mit dem Antennenanschluß (1) und einem Abgriff der Serienschaltung verbundenen Spulenanordnung, die im Vorkreisfilter (12) eine Anpassungsspule (37) ist, die zwischen dem Antennenanschluß (1) und dem Verbindungspunkt (36) der zweiten und der dritten Spule (31 und 32) liegt, zu deren Reihenschaltung der einzige Bereichsschalter (35) parallel geschaltet ist, wobei die erste Spule (30) frequenzbestimmend für den hohen Frequenzbereich ist.

2. Eingangsschaltung nach Anspruch 1, dadurch gekennzeichnet, daß der Kondensator (33) des Vorkreisfilters (12) veränderbar ist.

3. Eingangsschaltung nach Anspruch 1 oder 2, dadurch gekennzeichnet, daß die Anpassungss Spule (37) in Serie zur Parallelschaltung der zweiten und dritten Spule (31 und 32) als Anpassungselement für den hohen Frequenzbereich bemessen ist.

4. Eingangsschaltung nach Anspruch 1 oder einem der folgenden, dadurch gekennzeichnet, daß parallel zum Bereichsschalter (35) ein Korrekturkondensator (38) liegt.

5. Eingangsschaltung nach Anspruch 1 oder einem der folgenden, dadurch gekennzeichnet, daß der Ausgang des Vorkreisfilters (12) an einen Eingang (14) eines Vorverstärkers (15) angeschaltet ist, daß der Ausgang des Vorverstärkers (15) an eine zweistufige Umschalteinrichtung (17) gelegt ist, die gleichzeitig mit dem Vorkreisfilter (15) umgeschaltet wird und an die getrennt eigenständige Bandfilter (19,21) angeschlossen sind und daß die Ausgänge (23,24) der Bandfilter (19,21) je an eine eigene Mischstufe (25,26) angeschlossen sind.

6. Eingangsschaltung nach Anspruch 5, dadurch gekennzeichnet, daß an den Ausgang (16) des Vorverstärkers (15) einerseits ein Bandfilter (21) für den hohen Frequenzbereich über einen zweiten Kondensator (39) und andererseits ein Bandfilter (19) für den tiefen Frequenzbereich über die Reihenschaltung aus einer Hochpaßspule (40) und einen dritten Kondensator (43) angeschaltet ist und daß zwischen dem Verbindungspunkt (45) der Hochpaßspule (40) mit dem dritten Kondensator (43) und Massepotential ein Bandschalter (42) liegt.

7. Eingangsschaltung nach Anspruch 6, dadurch gekennzeichnet, daß bei geschlossenem Bandschalter (42) der zweite Kondensator (39) mit der Hochpaßspule (40), die HF-mäßig über einen vierten Kondensator (44) an Masse liegt, einen Hochpaß für den hohen Frequenzbereich bildet und das Bandfilter (19) für den niedrigen Frequenzbereich eingangsseitig kurzgeschlossen ist.

8. Eingangsschaltung nach Anspruch 6 oder 7 , dadurch gekennzeichnet, daß bei nichtleitendem Bandschalter (42) die Hochpaßspule (40) mit dem Kondensator, gebildet durch den zweiten Kondensator (39) und die Eingangsimpedanz des Bandfilters (21) einen Bandpaß für den tiefen Frequenzbereich bildet und das Bandfilter (21) für den hohen Frequenzbereich verstimmt ist.

9. Eingangsschaltung nach Anspruch 6, 7 oder 8, dadurch gekennzeichnet, daß parallel zum Bandschalter (42) eine Hochfrequenzdrossel (41) liegt, die einseitig an eine Gleichstromquelle (46) angeschlossen ist und daß der Ausgang (16) des Vorverstärkers (15) gleichstrommäßig mit dem aktiven Verstärkerelement verbunden ist.

10. Eingangsschaltung nach Anspruch 6, 7 oder 8, dadurch gekennzeichnet, daß der Verbindungspunkt (45) der Hochpaßspule (40) mit dem dritten Kondensator (43) einerseits über den Bandschalter (42) und einen Abblockkondensator (44) hochfrequenzmäßig an Massepotential und gleichstrommäßig über eine Schaltecke an eine Spannungsquelle (46) und andererseits über die Serienschaltung aus einer Hochfrequenzdrossel (41), einer Diode (48) und einer weiteren Schaltstrecke an eine Spannungsquelle (46) anschaltbar ist.

11. Eingangsschaltung nach Anspruch 1 oder einem der folgenden, dadurch gekennzeichnet, daß zwischen den Antennenanschluß (1) und das Vorkreisfilter (12) ein erster Bereichsumschalter (2) gelegt ist, daß an den Antennenanschluß (1) ein zweiter Bereichsumschalter (3) angeschlossen ist, der einem UHF-Tunerzweig vorgeschaltet ist und daß der Ausgang der Mischstufe (7) des UHF-Tunerzweiges zusammen mit den Ausgängen der anderen Mischstufen (25,26) an einen Zwischenfrequenz-Selektor (9) angeschlossen ist, der einen gemeinsamen Zwischenfrequenzausgang (11) aufweist.

## Claims

1. Input circuit of a television tuner for the frequency band from VHF-band I up to inclusively Hyperband including a preliminary circuit filter (12) consisting of a frequency determining capacitor (33) for the whole frequency range and, connected in parallel therewith, a series circuit consisting of three frequency determining coils (30, 31, 32) for the low frequency range of which the first (30) like the capacitor (33) has one end at earth potential and the third (32) like the capacitor (33) has one end connected to an output of the input circuit, and including a range change switch (35) inserted in this series circuit as well as an antenna terminal (1) and a coil arrangement connected to the antenna terminal (1) and to a tapping point of the series circuit, the coil arrangement being a matching coil (37) in the preliminary circuit filter (12) which matching coil is located between the antenna terminal (1) and the connection point (36) of the second and the third coil (31 and 32) to whose series circuit the single range change switch (35) is connected in parallel whereby the first coil (30) is the frequency determining member for the high frequency range.

2. Input circuit in accordance with Claim 1, characterised in that, the capacitor (35) of the preliminary circuit filter (12) is variable.

3. Input circuit in accordance with Claim 1 or 2, characterised in that, the matching coil (37) in series with the parallel circuit of the second and third coil (31 and 32) is dimensioned as a matching element for the high frequency range.

4. Input circuit in accordance with Claim 1 or any of the following ones, characterised in that, a compensating capacitor (39) is located in parallel with the range change switch (35).

5. Input circuit in accordance with Claim 1 or and of the following ones, characterised in that, the output of the preliminary circuit filter (12) is connected to an input (14) of a preamplifier (15), that the output of the preamplifier (15) is connected to a two stage switching device (17) that is switched over at the same time as the preliminary circuit filter (15) and are connected to the separate independent band pass filters (19, 21) and that the outputs (23, 24) of the band pass filters (19, 21) are each connected to a separate mixer stage (25, 26).

6. Input circuit in accordance with Claim 5, characterised in that, on the one hand, a band pass filter (21) for the high frequency range is connected via a second capacitor (39) to the output (16) of the preamplifier (15) and, on the other hand, a band pass filter (19) for the low frequency range is connected thereto via the series circuit of a high pass coil (40) and a third capacitor (43) and that a band change switch (42) is located between the connecting point (45) of the high pass coil (40) with the third capacitor (43) and earth potential.

7. Input circuit in accordance with Claim 6, characterised in that, for a closed band change switch (42), the second capacitor (39) together with the high pass coil (40) which is earthed via a fourth capacitor (44) as regards HF forms a high pass filter for the high frequency range and the band pass filter (19) for the low frequency range is short circuited on the input side.

8. Input circuit in accordance with Claim 6 or 7, characterised in that, for a non-conductive band change switch (42), the high pass coil (40) together with the capacitor formed by the second capacitor (39) and the input impedance of the band pass filter (21) forms a band pass filter for the low frequency range and the band pass filter (21) is detuned for the high frequency range.

9. Input circuit in accordance with Claim 6, 7 or 8, characterised in that, a high frequency choke (41) which is connected at one end to a direct current source (46) is located in parallel with the band change switch (42) and that, in a direct current sense, the output (16) of the preamplifier (15) is connected to the active amplifying element.

10. Input circuit in accordance with Claim 6, 7 or 8, characterised in that, the connection point (45) of the high pass coil (40) with the third capacitor (43) is connectible on the one hand via the bind change switch (42) and a non-blocking capacitor (44) to earth potential in a high frequency sense and via a switching path to a voltage source (46) in a direct current sense and on the other hand via the series circuit consisting of a high frequency choke (41), a diode (48) and a further switching path to a voltage source (46).

11. Input circuit in accordance with Claim 1 or any of the following ones, characterised in that, a first range change switch (2) is located between the antenna terminal (1) and the preliminary circuit filter (12), that a second range change switch (3) which is located before a UHF tuner branch is connected to the antenna terminal (1) and that the output of the mixer stage (7) of the UHF tuner branch together with the outputs of the other mixer stages (25, 26) is connected to in intermediate frequency selector (9) which has a common intermediate frequency output (11).

## Revendications

1. Circuit d'entrée d'un syntoniseur ou tête de récepteur de télévision pour la bande de fréquences allant de la bande des ondes métriques VHF-bande I jusqu'à et y compris l'hyperbande, comprenant un filtre de circuit de tête (12) formé d'un condensateur (33) de détermination de fréquence pour la gamme de fréquences mentionnée et d'un montage en série, branché en parallèle avec ce condensateur, de trois bobines (30, 31, 32) de détermination de fréquence pour la gamme inférieure de fréquences, dont la première bobine (30), comme le condensateur (33), est reliée par une extrémité au potentiel de la masse et la troisième bobine (32), comme le condensateur (33), est reliée par une extrémité à une sortie du circuit d'entrée, comprenant un interrupteur de gamme (35) inséré dans ce montage en série, et comprenant une prise d'antenne (1) et un dispositif de bobine relié à la prise d'antenne (1) et à une prise du montage en série, dispositif qui, dans le filtre de circuit de tête (12), est une bobine d'adaptation (37) disposée entre la prise d'antenne (1) et le point de connexion (36) de la deuxième (31) et de la troisième bobine (32), avec le montage en série desquelles est branché en parallèle l'unique interrupteur de gamme (35), la première bobine (30) étant déterminante pour la fréquence dans la gamme supérieure de fréquences.

2. Circuit d'entrée selon la revendication 1, caractérisé en ce que le condensateur (33) du filtre de circuit de tête (12) est variable.

3. Circuit d'entrée selon la revendication 1 ou 2, caractérisé en ce que la bobine d'adaptation (37), disposée en série avec le montage en parallèle de la deuxième (31) et de la troisième bobine (32), est dimensionnée pour former l'élément d'adaptation dans la gamme supérieure de fréquences.

4. Circuit d'entrée selon la revendication 1 ou une des revendications suivantes, caractérisé en ce qu'un condensateur de correction (38) est branché en parallèle avec l'interrupteur de gamme (35).

5. Circuit d'entrée selon la revendication 1 ou une des revendications suivantes, caractérisé en ce que la sortie du filtre de circuit de tête (12) est connectée à une entrée (14) d'un préamplificateur (15), que la sortie du préamplificateur (15) est reliée à un dispositif de commutation (17) à deux étages, dispositif qui est commuté en même temps que le filtre de circuit de tête (12) et auquel sont raccordés séparément des filtres de bande (19, 21) autonomes, et que les sorties (23, 24) des filtres de bande (19, 21) sont connectées chacune à un étage mélangeur (25, 26) indépendant.

6. Circuit d'entrée selon la revendication 5, caractérisé en ce que, à la sortie (16) du préamplificateur (15), sont connectés d'une part un filtre de bande (21) pour la gamme supérieure de fréquences, à travers un deuxième condensateur (39), et d'autre part un filtre de bande (19) pour la gamme inférieure de fréquences, à travers le montage en série d'une bobine passe-haut (40) et d'un troisième condensateur (43), et qu'un interrupteur de bande (42) est prévu entre le point de connexion (45) de la bobine passe-haut (40) et du troisième condensateur (43) et le potentiel de la masse.

7. Circuit d'entrée selon la revendication 6, caractérisé en ce que, lorsque l'interrupteur de bande (42) est fermé, le deuxième condensateur (39) forme, avec la bobine passe-haut (40), laquelle est reliée à la masse, pour la haute fréquence, à travers un quatrième condensateur (44), un filtre passe-haut pour la gamme supérieure de fréquences et le filtre de bande (19) pour la gamme inférieure de fréquences est court-circuité du côté de l'entrée.

8. Circuit d'entrée selon la revendication 6 ou 7, caractérisé en ce que, lorsque l'interrupteur de bande (42) n'est pas conducteur, la bobine passe-haut (40) constitue, avec le condensateur formé par le deuxième condensateur (39) et l'impédance d'entrée du filtre de bande (21), un filtre passe-bande pour la gamme inférieure de fréquences, et le filtre de bande (21) pour la gamme supérieure de fréquences est désaccordé.

9. Circuit d'entrée selon la revendication 6, 7 ou 8, caractérisé en ce qu'une self-inductance à haute fréquence (41), connectée d'un côté à une source de courant continu (46), est branchée en parallèle avec l'interrupteur de bande (42), et que la sortie (16) du préamplificateur (15) est relié, pour le courant continu, à l'élément amplificateur actif.

10. Circuit d'entrée selon la revendication 6, 7 ou 8, caractérisé en ce que le point de connexion (45) de la bobine passe-haut (40) et du troisième condensateur (43) peut être connecté d'une part au potentiel de la masse, pour la haute fréquence, à travers l'interrupteur de bande (42) et un condensateur de blocage (44) et, pour le courant continu, à une source de tension (46) à travers un circuit de commutation, et peut être connecté d'autre part à une source de tension (46) à travers le montage en série d'une self-inductance à haute fréquence (41), d'une diode (48) et d'un circuit de commutation supplémentaire.

11. Circuit d'entrée selon la revendication 1 ou une des revendications suivantes, caractérisé en ce qu'un premier commutateur de gamme (2) est placé entre la prise d'antenne (1) et le filtre de circuit d'entrée (12), qu'un second commutateur de gamme (3), précédant une branche de syntoniseur UHF, est raccordé à la prise d'antenne (1), et que la sortie de l'étage mélangeur (7) de la branche de syntoniseur UHF est raccordée ensemble avec les sorties des autres étages mélangeurs (25, 26) à un sélecteur de fréquence intermédiaire (9) qui présente une sortie de fréquence intermédiaire (11) commune.
